# EUROPEAN PATENT SPECIFICATION

(11) **EP 4 107 811 B1**
(45) Date of publication and mention of the grant of the patent: **15.07.2026**
(21) Application number: 20830447.7
(22) Date of filing: 08.12.2020
(51) Int. Cl.: H01P 5/02

(54) **RADIO FREQUENCY (RF) ENERGY TRANSMISSION LINE TRANSISTION STRUCTURE**
HOCHFREQUENZ-(HF)-ENERGIE-ÜBERTRAGUNGSLEITUNG TRANSISTIONSSTRUKTUR
STRUCTURE DE TRANSITION DE LIGNE DE TRANSMISSION D'ÉNERGIE RADIOFRÉQUENCE (RF)

(30) Priority: 19.02.2020 US 202016794487
(43) Date of publication of application: 28.12.2022
(73) Proprietor: Raytheon Company, Waltham, Massachusetts 02451-1449 (US)
(72) Inventor: LAIGHTON, Christopher, M., Boxborough, Massachusetts 01719 (US); TRULLI, Susan, C., Lexington, Massachusetts 02421 (US); HARPER, Elicia, K., Chelsea, Massachusetts 02150 (US)
(74) Representative: Crowell & Moring U.K. LLP
(86) International application number: PCT/US2020/063698
(87) International publication number: WO 2021/167676

(56) References cited:
- US-A- 5 545 924
- US-A1- 2010 285 676
- US-A1- 2013 161 076
- US-A1- 2014 085 856
- US-A1- 2017 194 686
- US-B2- 7 613 009
- US-B2- 8 655 119

## Description

### TECHNICAL FIELD

This disclosure relates generally to radio frequency (RF) energy transmission line structures and more particularly to RF energy transmission line structures having a transition for coupling RF energy between a pair of RF transmission lines disposed in different elevations.

### BACKGROUND OF THE INVENTION

As is known in the art, RF transitions are used to connect one RF transmission line to another RF transmission line. One technique uses wire bonding wires. The length of the wire bonds however adds inductance which may adversely affect the performance of the transition. As is also known is the art there is a trend to use additive manufacturing techniques (3D printing) to facilitate in the formation of RF transmission line structures. For further background, US 2014/085856A describes a terminal portion configured to obtain electrical connection with a printed circuit board that includes: a first signal pad that is formed in a first conductor layer and is electrically separated from a ground layer, a pair of first ground pads that is formed in the first conductor layer to sandwich the first signal pad and is connected to the ground layer, a second signal pad that is formed in a second conductor layer and is connected to a signal line, a pair of second ground pads that is formed in the second conductor layer to sandwich the second signal pad and is electrically separated from the signal line, a third signal pad formed in a third conductor layer, and a pair of third ground pads formed in the third conductor layer to sandwich the third signal pad.

US 8,655,119B describes a connection device including: a ground electrode layer that is provided in a substrate, a first transmission path that is provided on the ground electrode layer via a dielectric layer, and a plurality of leads that are connected to the first transmission path and the ground electrode layer or the first transmission path and a plane that is electrically connected to the ground electrode layer. The plurality of leads are fitted into through holes that are provided in a second transmission path and a ground electrode on a flexible substrate to be electrically connected.

US 2017/0194686A describes a transmission line. A first signal conductor pattern, a first ground conductor pattern, and a second ground conductor pattern define a first transmission line with a strip line structure. A second signal conductor pattern, a third ground conductor pattern, and a fourth ground conductor pattern define a second transmission line with a strip line structure. A first connecting portion at an end of the first transmission line and a second connecting portion at an end of the second transmission line are stacked together so that the first ground conductor pattern is electrically connected to the third ground conductor pattern, the second ground conductor pattern is electrically connected to the fourth ground conductor pattern, and the first signal conductor pattern is electrically connected to the second signal conductor pattern.

US 2007/217175 A1 discloses an RF electronic component for mounting on a substrate including a housing; and at least one electronic device having an input and/or output incorporated in the housing. At least one input/output terminal connects to a connection pad on the substrate; and an electrical transition provides an electrical connection between the input/output terminal and an input/output of an electronic device incorporated in the electronic component. The electrical transition comprises a side termination at least partially located on an outer surface of the housing; and an array of conductive through holes formed inside the housing at an offset from the side termination. The array is arranged so that the axes of the through holes are substantially mutually parallel and coplanar, and the array of through holes is connected to form a ground plane at the offset from the side termination.

US 5 545 924 A discloses a three-dimensional interconnect package for monolithic microwave/millimeterwave integrated circuits. A mating substrate for receiving an MMIC has transmission lines disposed over its surfaces. The mating substrate is mounted substantially vertical in a base substrate which also has transmission lines for carrying microwave/millimeterwave signals. The transmission lines on both substrates are put in electrical contact and microwave/millimeterwave signals are transmitted between the substrates with a minimum of signal loss or reflection.

### SUMMARY OF THE INVENTION

In accordance with the present disclosure, there is provided an RF energy transmission line transition according to claim 1. Further embodiments are defined in the dependent claims.

The details of one or more embodiments of the disclosure are set forth in the accompanying drawings and the description below. Other features, objects, and advantages of the disclosure will be apparent from the description and drawings, and from the claims.

### BRIEF DESCRIPTION OF THE DRAWINGS

FIG. 1 is a perspective view of a radio frequency transmission transition, bonded to a heat sink, for coupling an upper microwave transmission line section to a lower microwave transmission line section according to the disclosure;
FIG. 1A is a perspective view of an enlarged portion of the transition of FIG. 1, such enlarged portion being encircled by the arrow 1A-1A in FIG. 1;
FIG. 2 is a cross-section view of the transition of FIG.1 according to the disclosure;
FIG. 2A is a cross section of an enlarged portion of the transition of FIG. 2, such enlarged portion being encircled by the arrow 2A-2A in FIG. 2;
FIG. 3 is an exploded, perspective view of a radio frequency transmission transition, of FIG. 1 according to the disclosure;
FIG. 4A is cross sectional view of the transition of FIG. 1, such cross section being taken along line 4A-4A of FIG. 1;
FIG. 4B is cross sectional view of the transition of FIG. 1, such cross section being taken along line 4B-4B of FIG. 1;
FIGS. 5A, 5B and 5C, show sequential steps used to process a block used in the transition of FIG.1 according to the disclosure; and
FIGS. 6A, 6B and 6C, show sequential steps used to process another block used in the transition of FIG.1 according to the disclosure.

Like reference symbols in the various drawings indicate like elements.

### DETAILED DESCRIPTION

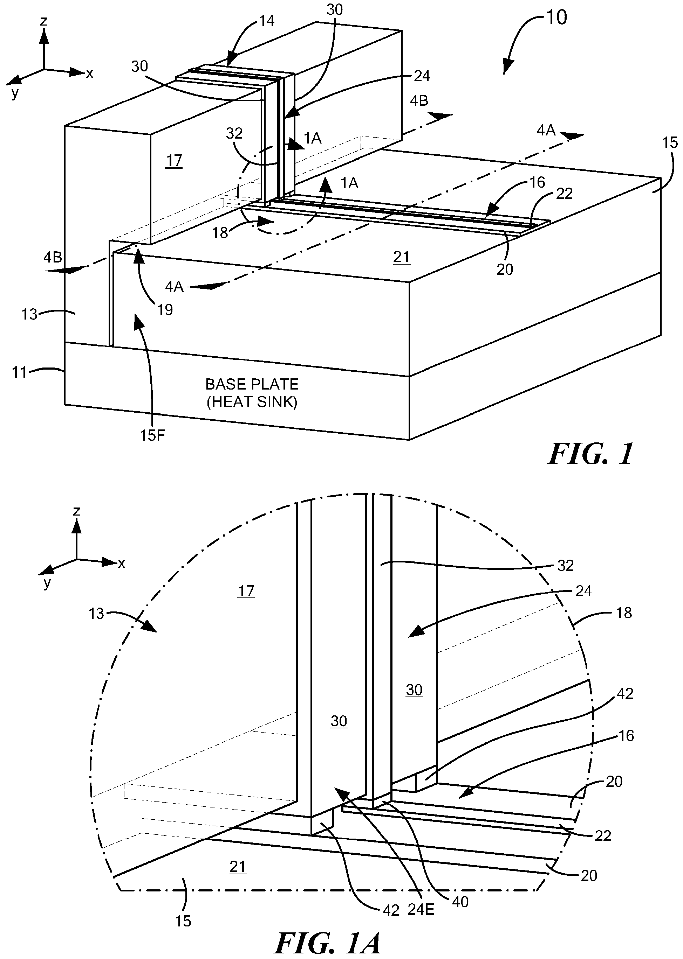

Referring now to FIGS. 1, 1A, 2, 2A, 3, a radio frequency transmission transition 10 is shown disposed on and bonded to an electrically conductive, baseplate or mounting medium, here for example a heat sink 11. The transition 10 couples an first, upper microwave transmission line section 14, here for example a microstrip transmission line, disposed in the X-Y (horizontal) plane at one elevation along a Z-axis to a second, lower microwave transmission line section 16, here for example a microstrip transmission line, disposed in the X-Y (horizontal) plane at different, here lower elevation along the Z-axis through a transition region, or section 18.

More particularly, the radio frequency transmission transition 10 includes a pair of electrically conductive blocks 13 and 15, which may also be thermally conductive. Block 13 has a vertical wall 17 with a jog 19 therein to receive a forward end of block 15, as shown. More particularly, the second radio frequency transmission line section 16, here for example, is a microstrip transmission line having: a first, horizontal, electrically conductive member, here the block 15, serving as a ground plane conductor for the second microstrip transmission line section 16, and having a horizontal surface 21 (disposed in the X-Y plane); a first dielectric 20, here a dielectric stripe, disposed on the horizontal surface 21 of block 15; and a first electrically conductive strip 22 disposed on a horizontal surface of the first dielectric 20, the first electrically conductive strip 22 serving as a signal conductor microstrip transmission line section 16.

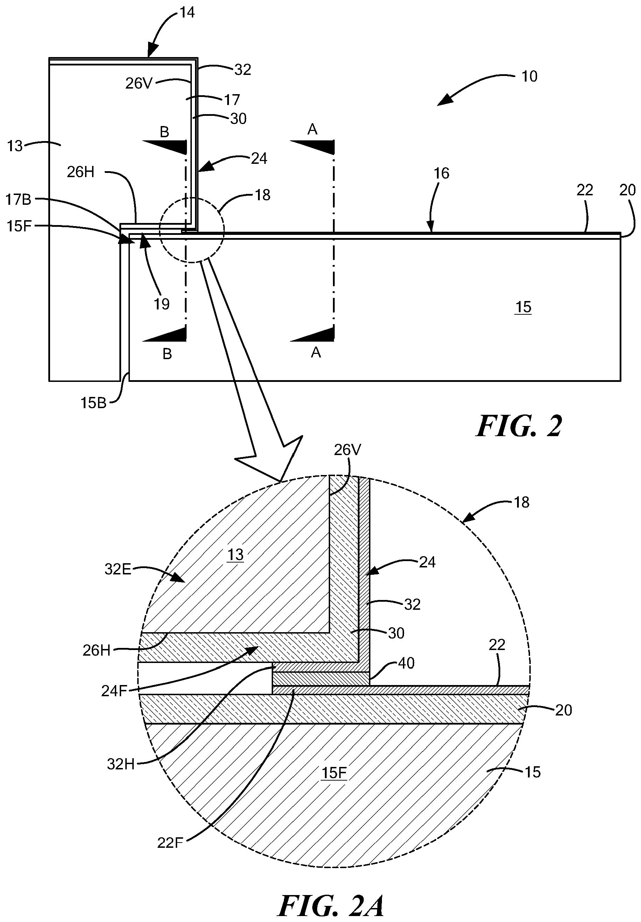

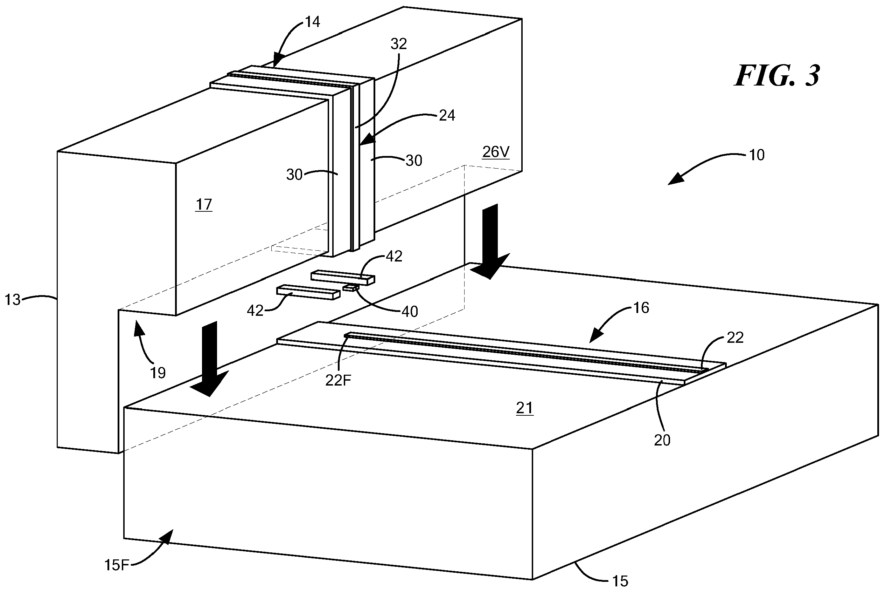

It is noted that the transition section 18 (FIGS. 1, 1A, 2 and 2A) includes: the forward end 15F (FIG. 3) of block 15 disposed in jog 19 which is an extension of a ground plane conductor of the lower microstrip transmission line 16, the forward portion of dielectric 20 disposed in jog 19 which is an extension of a dielectric of the lower microstrip transmission line 16; and the forward portion of the electrically conductive strip conductor 22 which is an extension of the signal strip conductor of the lower microstrip transmission line, 16, as shown more clearly in FIGS. 2, 2A and 3).

The transition 10 includes a reverse facing (in FIG. 2) L-shaped, second radio frequency transmission line section 24, here for example, a microstrip transmission line having: a second electrically conductive member 26, here block 13, shown more clearly in FIGS. 2 and 2A), serving as a ground plane for the microstrip transmission line section 24, as well as serving as a ground plane conductor for the upper microstrip transmission line 14, having a vertical surface portion 26V (disposed in the X-Z plane), and a horizontal surface portion 26H disposed in the X-Y plane; a second dielectric 30, here a dielectric stripe, disposed on the vertical surface portion 26V and the horizontal surface portion 26H of the second electrically conductive member 26; and a second electrically conductive strip 32 disposed on a vertical surface portion 30V and the horizontal portion 30H of the second dielectric 30; serving as a signal conductor microstrip transmission line section 24. It is noted, as shown more clearly in FIGS. 1A and 2A, the transition 10 couples RF energy between the pair of RF transmission line sections 16, 24, such transmission line sections 16, 24 being disposed in intersecting planes, here for example, orthogonal planes. Thus the transition 10 is here a 90 degree transition.

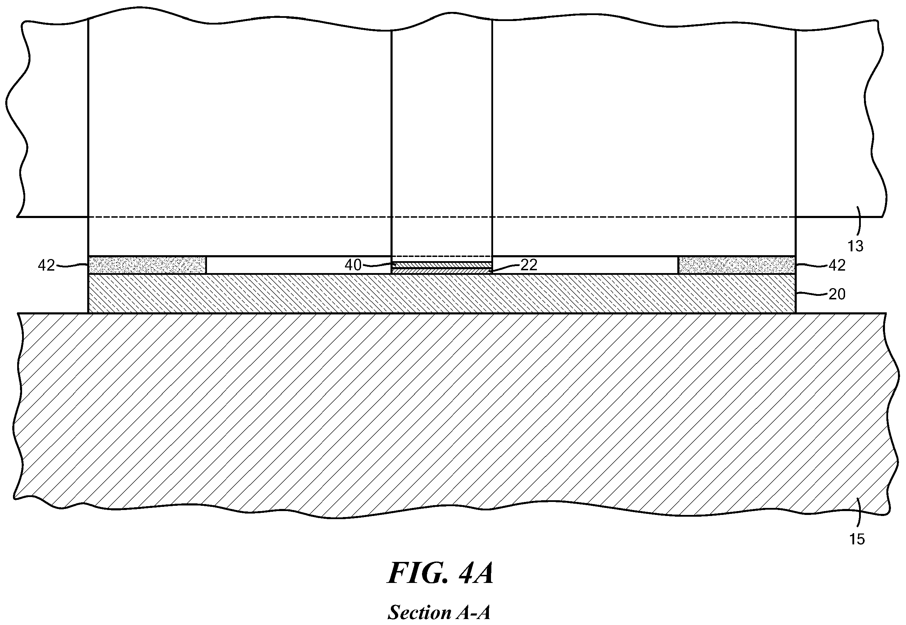

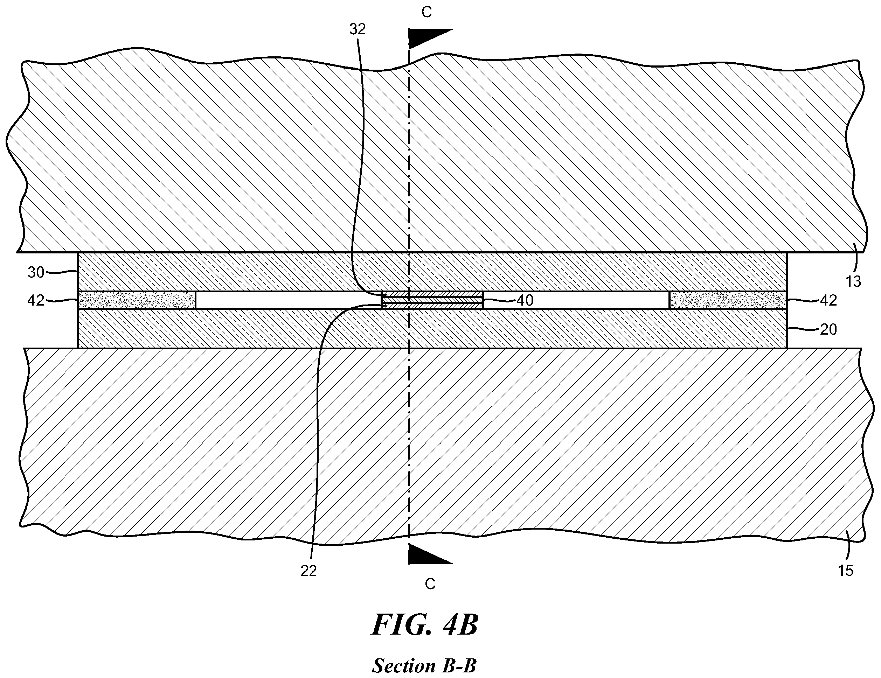

The transition section or region 18, shown more clearly in FIGS. 1A and 2A, includes the end portion 24F of the reverse facing (in FIG. 2) L-shaped, second radio frequency transmission line section 24 and the forward end 15F (FIG. 3) of block 15. The bottom portion of the horizontal portion 32H of strip conductor 32 is disposed on, and electrically connected to, the end portion 22F of the strip conductor 22 with here an electrically conductive bonding material 40 (FIG. 3), or a conductive ink when using additive manufacturing (3D printing) to fabricate the transition 10, as shown more clearly in FIGS. 1A, 3, 3A, 3B, 4A and 4B. It is also noted that a dielectrics attachment material 42 is also deposited on, or 3D printed on the dielectric 20, as shown more clearly in FIGS. 3, 4A and 4B. It is noted that the ends of the horizontal portion 32H of the strip conductor 32 and the front portion 22F of strip conductor 22 are spaced from the rear wall 15B of the block 15 and hence spaced from the vertical, jog portion 19 of wall 17 as shown in FIGS. 2, 2A and 3 to prevent them from contacting, and thereby electrically short circuiting, to the bottom, narrower portion of wall 17. It should be understood that other method are arrangements may be used to prevent them from contacting and thereby electrically short circuiting to the bottom, narrower portion (region 17B) of wall 17.

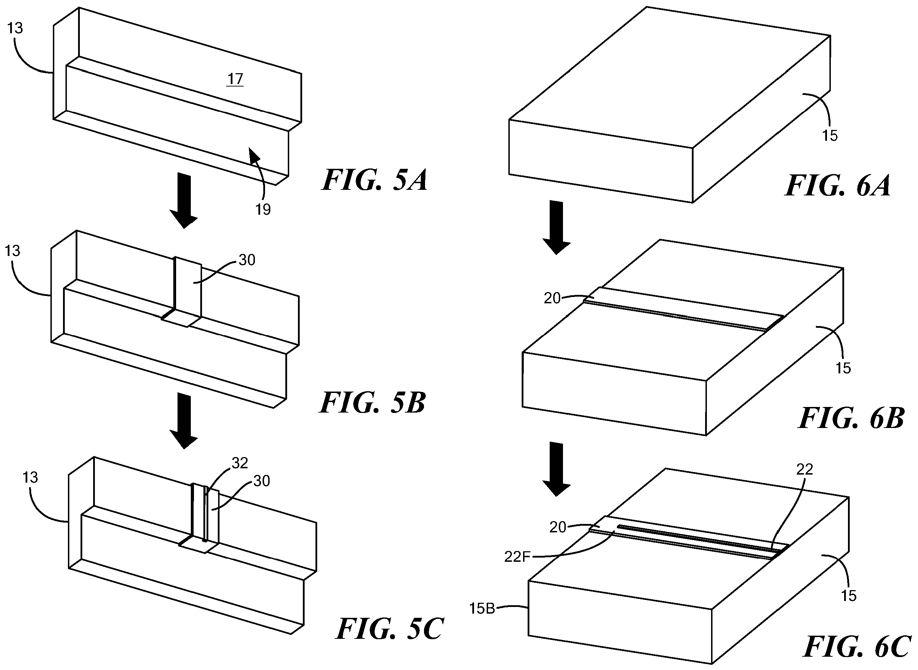

Referring now to FIGS. 5A, 5B and 5C, the sequential steps used to process block 13 are shown, and referring to FIGS. 6A, 6B and 6C, the sequential steps used to process block 15 are shown. Thus, referring to FIG. 5A the block 13 has the dielectric 3D printed as shown in FIG. 5B and the strip conductor 3D printed on the dielectric as shown in FIG. 5C. Thus, referring to FIG. 6A the block 15 has the dielectric 3D printed as shown in FIG. 6B and the strip conductor printed on the dielectric as shown in FIG. 6C. It is noted that the blocks 13, 15 may be created using Additive Manufacturing to create two pieces that can be overlapped/ fit together to form a true 90 degree angle transition 10.

The upper and lower may be connected to electrical components such as Monolithic Microwave Integrated Circuits (MMICs) or may be used in other 3D structures such as described in Patent U. S. Application Publication No.2019/0313522 A, entitled, "CIRCUIT SUPPORT AND COOLING STRUCTURE", Published October 10, 2019, inventors Trulli et al, assigned to the same assignee as the present patent application. The scope of the present invention is defined by the appended claims.

## Claims

1. A radio frequency, RF, energy transmission line transition for coupling RF energy comprises: a pair of RF transmission line sections (24, 16) disposed on intersecting orthogonal surfaces (26V, 21) of a corresponding one of a pair of conductive members (13, 15),
wherein a first one (13) of the pair of conductive members has a wall (17) with a recess therein for receiving an end portion (15F) of a second one (15) of the pair of conductive members,
wherein an end portion of a first electrically conductive strip (32) of a first one (24) of the pair of RF transmission line sections is disposed on, and electrically connected to, an end portion of a second electrically conductive strip (22) of a second one (16) of the pair of RF transmission line sections;
wherein the first electrically conductive strip (32) of the first RF transmission line section (24) is entirely disposed on two surfaces of the first conductive member (13),
wherein the two surfaces of the first conductive member (13) comprise a first surface and a second surface orthogonal to the first surface.

2. The RF energy transmission line transition of claim 1, wherein:
the first RF transmission line section (24) is disposed on a first one (26V) of the intersecting surfaces and comprises:
the first conductive member (13), the first conductive member (13) having a first surface portion disposed on the first intersecting surface (26V) and a second surface portion (26H) disposed on a second one (21) of the intersecting surfaces;
a first dielectric (30) disposed on the second surface portion (26H) and the first surface portion of the first conductive member (13); and
the first electrically conductive strip (32) wherein the end portion of the first electrically conductive strip (32) is disposed on the first dielectric (30) on both the second surface portion and the first surface portion of the first conductive member (13);
the second RF transmission line section (16) is disposed on the second intersecting surface (21) and comprises:
the second conductive member (15);
a second dielectric (20) disposed on the second conductive member (15); and
the second electrically conductive strip (22), wherein the end portion of the second electrically conductive strip (22) is disposed on the second dielectric (20); and
the end portion of the first electrically conductive strip (32) disposed on the second surface portion of the first conductive member (13) is disposed on and electrically connected to the second electrically conductive strip (22).

3. The RF energy transmission line transition recited in claim 2 wherein the first conductive member (13) comprises a block of conductive material.

## Patentansprüche

1. Übergang für eine Hochfrequenz(HF)-Energie-Übertragungsleitung zum Einkoppeln von HF-Energie, umfassend:
ein Paar von HF-Übertragungsleitung-Teilabschnitten (24, 16), das auf sich schneidenden orthogonalen Oberflächen (26V, 21) eines entsprechenden einen von einem Paar von elektrisch leitfähigen Elementen (13, 15) angeordnet ist,
wobei ein erstes (13) des Paares von elektrisch leitfähigen Elementen eine Wand (17) mit einer darin befindlichen Aussparung zum Aufnehmen eines Endabschnitts (15F) eines zweiten (15) des Paares von elektrisch leitfähigen Elementen aufweist,
wobei ein Endabschnitt eines ersten elektrisch leitfähigen Streifens (32) eines ersten (24) des Paares von HF-Übertragungsleitung-Teilabschnitten auf einem Endabschnitt eines zweiten elektrisch leitfähigen Streifens (22) eines zweiten (16) des Paares von HF-Übertragungsleitung-Teilabschnitten angeordnet und elektrisch mit diesem verbunden ist;
wobei der erste elektrisch leitfähige Streifen (32) des ersten HF-Übertragungsleitung-Teilabschnitts (24) vollständig auf zwei Oberflächen des ersten elektrisch leitfähigen Elements (13) angeordnet ist,
wobei die zwei Oberflächen des ersten elektrisch leitfähigen Elements (13) eine erste Oberfläche und eine zweite Oberfläche orthogonal zu der ersten Oberfläche umfassen.

2. Übergang für HF-Energie-Übertragungsleitung nach Anspruch 1, wobei:
der erste HF-Übertragungsleitung-Teilabschnitt (24) auf einer ersten (26V) der sich schneidenden Oberflächen angeordnet ist und Folgendes umfasst:
das erste elektrisch leitfähige Element (13), wobei das erste elektrisch leitfähige Element (13) einen ersten Oberflächenabschnitt, der auf der ersten schneidenden Oberfläche (26V) angeordnet ist, und einen zweiten Oberflächenabschnitt (26H), der auf einer zweiten (21) der sich schneidenden Oberflächen angeordnet ist, aufweist;
ein erstes Dielektrikum (30), das auf dem zweiten Oberflächenabschnitt (26H) und dem ersten Oberflächenabschnitt des ersten elektrisch leitfähigen Elements (13) angeordnet ist; und
den ersten elektrisch leitfähigen Streifen (32), wobei der Endabschnitt des ersten elektrisch leitfähigen Streifens (32) auf dem ersten Dielektrikum (30) sowohl auf dem zweiten Oberflächenabschnitt als auch dem ersten Oberflächenabschnitt des ersten elektrisch leitfähigen Elements (13) angeordnet ist;
wobei der zweite HF-Übertragungsleitung-Teilabschnitt (16) auf der zweiten schneidenden Oberfläche (21) angeordnet ist und Folgendes umfasst:
das zweite elektrisch leitfähige Element (15);
ein zweites Dielektrikum (20), das auf dem zweiten elektrisch leitfähigen Element (15) angeordnet ist; und
den zweiten elektrisch leitfähigen Streifen (22), wobei der Endabschnitt des zweiten elektrisch leitfähigen Streifens (22) auf dem zweiten Dielektrikum (20) angeordnet ist; und
wobei der Endabschnitt des ersten elektrisch leitfähigen Streifens (32), der auf dem zweiten Oberflächenabschnitt des ersten elektrisch leitfähigen Elements (13) angeordnet ist, auf dem zweiten elektrisch leitfähigen Streifen (22) angeordnet und
elektrisch mit diesem verbunden ist.

3. Übergang für HF-Energie-Übertragungsleitung nach Anspruch 2, wobei das erste elektrisch leitfähige Element (13) einen Block aus elektrisch leitfähigem Material umfasst.

## Revendications

1. Transition de ligne de transmission d'énergie radiofréquence, RF, pour le couplage de l'énergie RF comprend : une paire de sections de ligne de transmission RF (24, 16) disposées sur des surfaces orthogonales d'intersection (26V, 21) de l'un des éléments conducteurs correspondants d'une paire d'éléments conducteurs (13, 15),
dans lequel un premier élément (13) de la paire d'éléments conducteurs comporte une paroi (17) dotée d'un évidement destiné à recevoir une partie d'extrémité (15F) d'un second élément (15) de la paire d'éléments conducteurs,
dans lequel une partie d'extrémité d'une première bande électriquement conductrice (32) d'une première section (24) de la paire de sections de ligne de transmission RF est disposée sur, et connectée électriquement à, une partie d'extrémité d'une seconde bande électriquement conductrice (22) d'une seconde section (16) de la paire de sections de ligne de transmission RF ;
dans lequel la première bande électriquement conductrice (32) de la première section de ligne de transmission RF (24) est entièrement disposée sur deux surfaces du premier élément conducteur (13),
dans lequel les deux surfaces du premier élément conducteur (13) comprennent une première surface et une seconde surface orthogonale à la première surface.

2. Transition de ligne de transmission d'énergie RF selon la revendication 1, dans laquelle :
la première section de ligne de transmission RF (24) est disposée sur une première surface (26V) des surfaces d'intersection et comprend :
le premier élément conducteur (13), le premier élément conducteur (13) ayant une première partie de surface disposée sur la première surface d'intersection (26V) et une seconde partie de surface (26H) disposée sur une seconde surface (21) des surfaces d'intersection ;
un premier diélectrique (30) disposé sur la seconde partie de surface (26H) et la première partie de surface du premier élément conducteur (13) ; et
la première bande électriquement conductrice (32) dans laquelle la partie d'extrémité de la première bande électriquement conductrice (32) est disposée sur le premier diélectrique (30) à la fois sur la seconde partie de surface et sur la première partie de surface du premier élément conducteur (13) ;
la seconde section de ligne de transmission RF (16) est disposée sur la seconde surface d'intersection (21) et comprend :
le second élément conducteur (15) ;
un second diélectrique (20) disposé sur le second élément conducteur (15) ; et
la seconde bande électriquement conductrice (22), dans laquelle la partie d'extrémité de la seconde bande électriquement conductrice (22) est disposée sur le second diélectrique (20) ; et
la partie d'extrémité de la première bande électriquement conductrice (32) disposée sur la seconde partie de surface du premier élément conducteur (13) est disposée sur et connectée électriquement à la seconde bande électriquement conductrice (22).

3. Transition de ligne de transmission d'énergie RF selon la revendication 2, dans laquelle le premier élément conducteur (13) comprend un bloc de matériau conducteur.
